(19) **Europäisches Patentamt / European Patent Office / Office européen des brevets**

(11) **EP 4 443 771 A1**

(12) # EUROPEAN PATENT APPLICATION

(43) Date of publication:
**09.10.2024 Bulletin 2024/41**

(21) Application number: **23166388.1**

(22) Date of filing: **03.04.2023**

(51) International Patent Classification (IPC):
**H04B 10/61** $^{(2013.01)}$    **G05B 13/00** $^{(2006.01)}$
**H03L 7/00** $^{(2006.01)}$

(52) Cooperative Patent Classification (CPC):
**H04B 10/6165; H03L 7/0812**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Nederlandse Organisatie voor toegepast-natuurwetenschappelijk Onderzoek TNO**
  **2595 DA 's-Gravenhage (NL)**
• **Technische Universiteit Delft**
  **2628 CN Delft (NL)**

(72) Inventors:
• **BIEMOND, Jan Jacobus Benjamin**
  **2595 DA 's-Gravenhage (NL)**
• **STOLK, Adriaan Johannes**
  **2628 CN Delft (NL)**
• **VAN DER ENDEN, Kian Louran**
  **2628 CN Delft (NL)**
• **VAN ZWET, Erwin John**
  **2595 DA 's-Gravenhage (NL)**
• **MESKERS, Adrianus Johannes Hendricus**
  **2595 DA 's-Gravenhage (NL)**

(74) Representative: **V.O.**
  **P.O. Box 87930**
  **2508 DH Den Haag (NL)**

(54) **A METHOD AND SYSTEM FOR CONTROLLING OUTPUT SIGNALS OF A FIRST DYNAMIC SYSTEM AND A SECOND DYNAMIC SYSTEM**

(57)    A method and control system for controlling output signals of a system comprising a first and a second dynamic system, which receive a first and second input signal and output a first and second output signal, respectively. The method involves using a first control system to generate first control signals to compensate for the first and second output signals based on the difference between the output signal and a reference signal. A second control system generates one or more second control signals based on the difference between the first and second output signals. The second control signal is used for further compensating the output signals, and/or the first control system further compensates the output signals based on the second control signal. The first and second control systems have different closed-loop bandwidths, with the second being smaller than the first.

FIG 1

Processed by Luminess, 75001 PARIS (FR)

**Description**

FIELD OF THE INVENTION

The invention relates to a method of controlling output signals of a system including at least a first dynamic system and a second dynamic system. Additionally, the invention relates to a system for controlling output signals of a system including at least a first dynamic system and a second dynamic system. Furthermore, the invention relates to controlled synchronization, more particularly a method and system of performing controlled synchronization of a first optical signal and a second optical signal.

BACKGROUND TO THE INVENTION

Controlling output signals of dynamic systems is used in various applications. For example, synchronization is a technique where two or more systems come into an agreement in terms of their behavior. Synchronization is an important concept that has various applications, such as for example (tele)communication, control, signal processing, quantum computation, etc. The concept of controlled synchronization has been studied extensively in order to achieve identical behavior despite different initial conditions and inputs. In controlled synchronization, one system may be designed to influence the behavior of another system to achieve a desired output.

Controlled synchronization involves forcing two or more systems to exhibit substantially identical behavior despite different inputs and initial conditions. The systems can be either linear or nonlinear, and the synchronization may be complete or partial. Partial synchronization occurs when certain components or states of the systems are synchronized while others remain desynchronized. On the other hand, complete synchronization occurs when all the components or states of the systems are synchronized.

Various methods have been proposed to achieve controlled synchronization, including adaptive control, feedback control, and sliding mode control. Adaptive control involves adjusting the control parameters to adapt to the changes in the systems. Feedback control involves using feedback signals to modify the behavior of the systems. Sliding mode control involves designing a sliding surface that forces the systems to converge to a desired state.

Controlled synchronization via direct error measurement can be bandwidth-limited in applications when a specific sensor needs to be used to measure the synchronization error, for example interference measurements by single-photon detectors in quantum interference experiments, or when the control implementation is bandwidth limited. There is a strong desire to better handle such bandwidth limitations.

One of the problems is the issue of synchronization error, which occurs when the systems exhibit a small difference in their behavior. This difference may be due to uncertainties, disturbances, or noise. Another problem is the issue of robustness, which refers to the ability of the synchronization to withstand uncertainties and disturbances. Robustness is crucial in real-world applications, where the systems may be subject to external disturbances. These aspects may also be influenced by the above-mentioned bandwidth issues.

In various applications, there is a technical problem regarding the inability to measure synchronization error quickly enough. This issue is compounded by a bandwidth limit, which affects both the measurement of the synchronization error and the processing of that measurement.

Various sources of limited measurement bandwidth exist, including shot noise which limits the bandwidth at which a sufficiently accurate measurement is feasible.

Noise and disturbances, which can arise from external sources or from the inherent stochasticity of the systems, can disrupt synchronization and make it difficult to achieve and maintain a stable synchronization state. Furthermore, the presence of delays in the coupling between the systems can also lead to desynchronization, making it challenging to achieve and maintain synchronization.

Therefore, there is a need to provide for improved control of output signals of dynamic systems, such as for example for controlled synchronization involving forcing two systems to have the same output despite of having (typically close but) different input signals and initial conditions, even when there are bandwidth limitations.

SUMMARY OF THE INVENTION

It is an object of the invention to provide for a method and a system that obviates at least one of the above mentioned drawbacks.

Additionally or alternatively, it is an object of the invention to improve the control of output signals of a system including a first dynamic system and a second dynamic system.

Additionally or alternatively, it is an object of the invention to enable controlled synchronization at bandwidths beyond the limit of direct synchronization error measurement.

Additionally or alternatively, it is an object of the invention to improve synchronizing of optical light paths.

Thereto, the invention provides for a method of controlling output signals of a system including at least a first dynamic system and a second dynamic system, wherein the first and second dynamic systems are configured to receive a first and second input signal and output a first and second output signal, respectively, wherein the method includes: providing a first control system that is configured to generate first control signals that are provided to the first dynamic system and the second dynamic system, respectively, in order to compensate the first output signal based on a difference between the first output signal and a first reference signal, and in order to compensate the second output signal based on a difference between the second output signal and a second reference signal; providing a second control system that is configured to generate one or more second control signals based on a difference between the first output signal and the second output signal; wherein the first control system is configured to perform compensation of the first output signal and/or the second output signal further based on the second control signal generated by the second control system; and/or wherein the second control system is configured to provide the one or more second control signals to at least one of the first dynamic system or the second dynamic system in order to compensate the first output signal or the second output signal, respectively; and wherein a first closed-loop bandwidth is associated to the first control system, wherein a second closed-loop bandwidth is associated to the second control system, and wherein the first and second control systems are configured such that the second closed-loop bandwidth is smaller than the first closed-loop bandwidth.

Advantageously, higher control bandwidths may be obtained, resulting in lower errors between two outgoing signals. This is of great importance for various applications, such as but not limited to synchronization of signals.

The method can handle control of output signals via direct error measurement that is bandwidth-limited for example at least partially due to sensors used for measuring the synchronization error, and/or at least partially due to limitations of the bandwidth of the control implementation.

When receiving incoming signals, using a fast controller and fast sensor, both the first and second dynamical system can be synchronized with a first and second reference signal. Subsequently, compensation for any remaining errors between the first and second dynamical system can be performed. While attempting to equalize the signal with the reference signal, low-frequency residual errors may occur. These errors can be compensated for using an additional sensor.

It will be appreciated that the closed-loop bandwidths may be a property determined by the respective control system, dynamic system, detectors, cabling, etc. The closed-loop bandwidth of a control system can be determined by the system's feedback loop and the characteristics of the components within the loop. The feedback loop in a control system is responsible for measuring the output of the system and comparing it to the desired input. The difference between the output and input is called the error signal. The feedback loop then uses this error signal to adjust the system's output and minimize the error. The characteristics of the components within the feedback loop, such as the sensors, amplifiers, and actuators, can also affect the closed-loop bandwidth. For example, if the sensors have a slower response time, they may limit the closed-loop bandwidth of the system. Additionally or alternatively, the controller used in the system can also affect the closed-loop bandwidth. A controller with a faster response time can improve the closed-loop bandwidth, while a slower controller can limit it.

Therefore, overall, the closed-loop bandwidth of the first and second control systems can be determined by the interaction between their feedback loop and the characteristics of the components and controller within their loop, respectively.

Optionally, the method and system according to the invention is used for controlled synchronization at bandwidths beyond the limit of direct synchronization error measurement. The outputs of the first dynamic system and the second dynamic system may be synchronized despite the presence of different uncontrolled inputs to the respective first and second dynamic systems.

Controlled synchronization refers to the process of ensuring that two systems have the same output despite having different input signals or initial conditions. However, direct error measurement in controlled synchronization can be limited in bandwidth in applications where specific sensors are used to measure the synchronization error. Also when the control implementation may be bandwidth-limited. To overcome both issues, the present invention proposes synchronizing both signals first using a high-bandwidth controller to reference signals with low high-frequency content. This approach ensures that high frequency signals in the residual synchronization error are avoided and the bandwidth limit is not an issue and controlled synchronization can be achieved by a controller using a direct error measurement, where either said controller or the error measurement is limited in bandwidth. By applying feedback at low bandwidth on the reference signals, synchronization is achieved. By selecting the reference signals close to the input signals, the control effort remains limited. The innovation is implemented on two light inputs to lock the phase of the output light to each other. The proposed approach involves using two controllers with different bandwidths, which goes beyond the current state of the art and provides synchronization solutions for optical synchronization problems.

When attempting to modify the wavelength of light, the achievable range may be relatively narrow. To achieve the desired wavelength, the reference signal may be adjusted to a value within the range that the actuators can handle. The term "close" indicates a value that is comfortably within the actuator's range.

The second control system may be used for direct and/or indirect control.

The second control system may perform direct control by providing the one or more second control signals to at least one of the first dynamic system or the second dynamic system (directly), in order to compensate the first output signal (for the first dynamic system) and/or the second output signal (for the second dynamic system). For example, the second control system may provide the second control signal to one of: the first dynamic system and the second dynamic system. In some other examples, the second control system may provide a primary second control signal to the first dynamic system and a secondary second control signal to the second dynamic system.

Additionally or alternatively, the second control system may be configured to perform indirect control, wherein the first control system is configured to perform compensation of the first output signal and/or the second output signal further based on the second control signal generated and provided by the second control system.

The method according to the disclosure can be employed in a wide range of potential applications. One such application is in synchronization processes that require high bandwidth criteria. It can also be used in optical synchronization processes where precise synchronization is critical. Additionally, the technology can be utilized in phase-locked photon paths for quantum internet, where maintaining phase coherence is essential for the proper functioning of quantum communication protocols.

The method can be employed in various applications in the field of quantum technology, such as for example for optical phase synchronization, for example in a quantum communication/internet system.

Optionally, the first control bandwidth is selected such that high-frequency content in the difference between the first output signal and the second output signal is smaller than a limit imposed by the controller of the second control system due to its second control bandwidth.

An acceptably low high-frequency content may be high-frequency content that is low enough so that the second controller can compensate for it.

The invention enables achieving controlled synchronization at bandwidths beyond the limit of direct synchronization error measurement. In optical phase synchronization problems, the measurement bandwidth may be limited by the shot noise of the direct synchronization error measurement. Classical solutions typically require high bandwidth for the synchronization error measurement. However, with the approach according to the disclosure, there is no need for high-bandwidth synchronization error measurement. Instead, it involves a combination of high bandwidth synchronization with reference signals and low bandwidth synchronization effort from synchronization error measurement. This helps to reduce the complexity of control signals.

In the prior art, the control signal may be not limited by bandwidth. Furthermore, some prior art does not encounter any problematic bandwidth limit on the control resulting from the error signal, nor were any external inputs involved.

Optionally, the first and second reference signals are selected such that a difference between the first and second reference signals and the first and second input signals, respectively, is smaller than a threshold value.

Optionally, the first control system is configured to perform compensation of both the first output signal and the second output signal based on the second control signal generated by the second control system; or wherein the first control system is configured to perform compensation of only one of the first output signal or the second output signal based on the second control signal generated by the second control system.

Optionally, the method is employed for synchronizing of optical light paths.

Optionally, the first and second dynamic systems are optical systems configured to receive first and second optical input signal and to output a first and second optical output signal, respectively, wherein the first and second optical input signals, the first and second optical output signals and the first and second reference signals are optical signals guided through optical light paths, and wherein nodes of the first and second control systems at which signals are added or subtracted are implemented by measuring interference amplitudes using one or more detectors.

Optionally, the first control system and the second control system are employed for phase locking the first and second optical input signals.

Optionally, the first and second dynamic optical systems are optical phase shifters or optical frequency shifters.

In some examples, the dynamic optical systems are configured to function as a phase shifter or any other system capable of processing time-varying input signals and generating relevant time-varying output signals.

Optionally, the first dynamic optical system is configured to receive at least two first optical input signals with different wavelengths, and wherein the second dynamic optical system is configured to receive at least two second optical input signals with different wavelengths, wherein a phase difference between the at least two first optical input signals and a phase difference between the at least two second optical input signals is determined, and wherein the first and/or second control signals are employed to apply optical phase shifts at the respective first and/or second dynamic optical systems to the at least two first and/or second optical input signals, respectively, to generate the at least two first and/or second optical output signals of the respective first and/or second dynamic optical systems.

Optionally, a primary first control signal is generated by the first control system based on an error signal obtained by interfering the first output signal with the first reference signal at a first detector and subsequently subtracting the second control signal received from the second control system, and wherein a secondary first control signal is generated by the first control system based on an error signal obtained by interfering the second output signal with the second reference signal at a second detector and subsequently subtracting the second control signal received from the second control system.

The first control signals may be generated by the first control system, for example a first controller of the first control system generating a primary first control signal and a second controller of the first control system generating a secondary first control signal. The one or more second control signals are generated by the second control system.

Optionally, the one or more second control signals are generated by the second control system based on an interference between the first output signal and a second output signal, and further based on the phase difference between the at least two first optical input signals and a phase difference between the at least two second optical input signals.

Optionally, the first and second reference signals are different.

Optionally, the first and second reference signals are the same.

Optionally, optical phase differences are measured heterodyne.

Optionally, optical phase differences are measured homodyne.

The homodyne method is a simpler approach, while heterodyne provides electronic advantages as the signal being measured is around a specific frequency (such as 200 MHz), resulting in less noise than measurements taken around DC. Compared to more simple homodyne solutions, heterodyne may be preferable for reducing low-frequency noise sources stemming from, e.g, detectors.

In some examples, the method is employed in quantum applications. Quantum information that needs to be compared or combined at two distinct points often relies on the phase of light. Therefore, it is crucial to maintain a constant optical phase when bringing the information together. This poses a synchronization challenge for quantum applications. The synchronization error can be detected using a sensor. The method according to the invention can be utilized to keep the optical phase of light paths synchronized.

Quantum interference is a crucial concept in quantum communication. In quantum communication, quantum interference is used to encode and transmit information through quantum states. For instance, in quantum key distribution, two parties can use the interference of quantum states to generate a shared secret key that can be used for secure communication. The parties can create two entangled quantum states and then measure them in a specific way, which will result in an interference pattern. The pattern will be different depending on whether an eavesdropper has intercepted the transmission or not, allowing the parties to detect any attempts at interception. Similarly, in quantum teleportation, quantum interference is used to transmit the quantum state of one system to another system without physically moving the system itself. The quantum state is measured, and the result is used to construct a new quantum state that is transmitted to the receiving system, where it interferes with another quantum state to recreate the original state. In both cases, the use of quantum interference allows for secure and efficient communication using quantum systems.

The optical phase and polarization of light particles from source A and source B may need to be compared to determine their degree of similarity. This comparison can then be used to develop a communication technique. In a first step a quantum interference may be created which will lead to entanglement between the quantum bits on both sides. This entanglement can then be utilized for various purposes, such as calculating, communicating, and/or exchanging cryptographic keys.

According to an aspect, the invention relates to a control system for controlling output signals of a system including at least a first dynamic system and a second dynamic system, wherein the first and second dynamic systems are configured to receive a first and second input signals and output a first and second output signal, respectively, wherein the system includes: a first control system configured to generate control signals that are provided to the first dynamic system and the second dynamic system, respectively, in order to compensate the first output signal based on a difference between the first output signal and a first reference signal, and in order to compensate the second output signal based on a difference between the second output signal and a second reference signal; a second control system configured to generate one or more second control signals based on a difference between the first output signal and the second output signal; wherein the first control system is configured to perform compensation of the first output signal and/or the second output signal further based on the second control signal generated by the second control system; and/or wherein the second control system is configured to provide the one or more second control signals to at least one of the first dynamic system or the second dynamic system in order to compensate the first output signal or the second output signal, respectively; and wherein a first closed-loop bandwidth is associated to the first control system, wherein a second closed loop bandwidth is associated to a second control system, and wherein the first and second control systems are configured such that the second closed-loop bandwidth is smaller than the first closed-loop bandwidth.

The invention allows for the achievement of higher synchronization bandwidths, resulting in lower errors between two outgoing signals. This is particularly useful for applications such as for example optical synchronization and phase-locked photon paths for quantum internet, where it enables the use of within-fringe control, even in the presence of large high-frequency differences between incoming signals.

According to an aspect, the invention provides for a method for controlling output signals of a system comprising a first and a second dynamic system, which receive a first and second input signal and output a first and second output signal, respectively. The method involves using a first control system to generate first control signals to compensate for the first and second output signals based on the difference between the output signal and a reference signal. A second control system generates one or more second control signals based on the difference between the first and second output signals. The first control system further compensates the output signals based on the second control signal, and the first and second control systems have different closed-loop bandwidths, with the second being smaller than the first.

It will be appreciated that any of the aspects, features and options described in view of the method apply equally to the system and the described device. It will also be clear that any one or more of the above aspects, features and options can be combined.

BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:

Fig. 1 shows a schematic diagram of an embodiment of a system;
Fig. 2 shows a schematic diagram of an embodiment of a system; and
Fig. 3 shows a schematic diagram of an embodiment of a system.

DETAILED DESCRIPTION

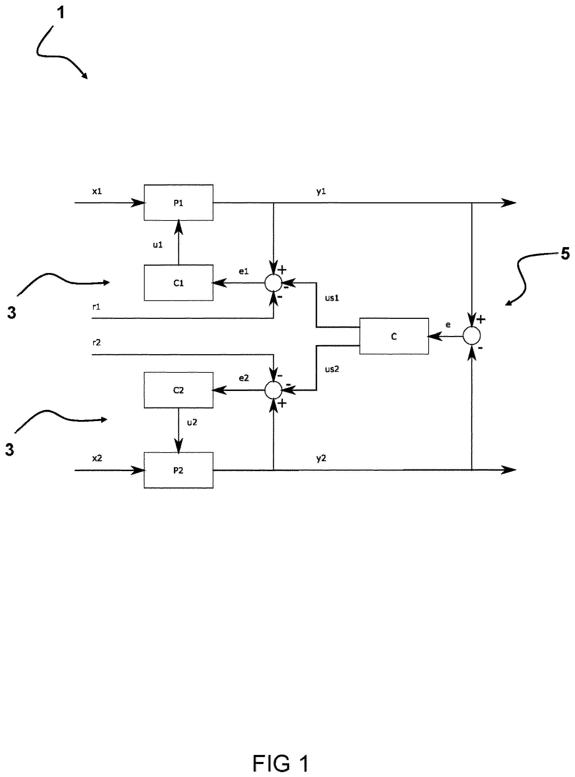

Fig. 1 shows a schematic diagram of an embodiment of a system 1. A control system is used for controlling output signals of a system including at least a first dynamic system P1 and a second dynamic system P2, wherein the first and second dynamic systems are configured to receive a first and second input signal X1, X2, and output a first and second output signal Y1, Y2, respectively. A first control system 3 (C1, C2) is provided that is configured to generate first control signals, namely primary first control signal U1 and secondary first control signal U2, that are provided to the first dynamic system P1 and the second dynamic system P2, respectively, in order to compensate the first output signal Y1 based on a difference between the first output signal Y1 and a first reference signal R1, and in order to compensate the second output signal Y2 based on a difference between the second output signal Y2 and a second reference signal R2. A second control system 5 (C) is provided that is configured to generate one or more second control signals US1, US2, based on a difference between the first output signal Y1 and the second output signal Y2. The first control system 3 is configured to perform compensation of the first output signal Y1 and/or the second output signal Y2 further based on the one or more second control signals US1, US2, generated by the second control system 5. A first closed-loop bandwidth is associated to the first control system 3, wherein a second closed-loop bandwidth is associated to the second control system 5, and wherein the first and second control systems 3, 5, are configured such that the second closed-loop bandwidth is smaller than the first closed-loop bandwidth.

The invention can be employed on various types of dynamic systems. The systems do not necessarily need to be optical systems. In some examples, the system has inputs and outputs that pertain to an optical problem, for example related to analyzing the optical phase of incoming light. In these cases, the dynamical systems P1 and P2 can be inserted in the optical paths to attain the desired synchronisation between y1 and y2. It will be appreciated that the dynamical systems P1 and P2 may be introduced as part of an arrangement to achieve synchronization.

The control system can be employed for synchronization of signals. In that case, the objective is to synchronize Y1 to Y2, even when systems P1, P2 have different uncontrolled inputs X1 and X2. The method may be applied to optical phase synchronization involving two wavelengths.

The first control signals (e.g. primary first control signal U1 generated by the first controller C1 of the first control system 3, and the secondary first control signal U2 generated by the second controller C2 of the first control system 3) may be electrical electronic/digital signals.

The goal may be to synchronize two signals, Y1 and Y2. This is achieved initially by calculating the difference between them, which produces a synchronization error E. This can be done by using this error signal in a controller. If the bandwidth of this signal is insufficient, additional measurements may be necessary to lower the high-frequency error between Y1 and Y2. This is accomplished by setting signal Y1 to match reference signal R1 and signal Y2 to match reference signal R2 before closing the control loop. It can be ensured that Y2 resembles R2 as closely as possible.

In some examples, the control system is utilized for synchronizing of optical light paths. However, the control system may also be used for other applications, such as non-optical applications or partially optical applications.

The control system may be configured to synchronize two systems to reference signals individually using a fast control loop and then applying a slow feedback based on error measurement of the relevant synchronization error measurement on the setpoint of fast loops. This invention is suitable for optical phase synchronization with multiple wavelengths.

It is possible that identical reference signals are chosen. However, it is also possible to employ two different reference signals. In the case of optical signals for example, the reference signal might have a wavelength in the middle range. First, R1 may be compared to Y1 (and R2 compared to Y2, respectively) and then the error can be minimized or reduced by closing the control loop, resulting in a fast loop. However, this process may still leave a residual error between Y1 and Y2, which could be due to various factors, such as external disturbances or imperfect controllers. To address this, the signal is continuously measured, and the setpoint of one or both controllers can be adjusted accordingly. The US1 and US2 path is employed for this purpose in this scenario.

Controllers C1 and C2 may be faster controllers compared to controller C. In some cases the measurements may be bandwidth limited. However, additionally or alternatively, it is also possible that the controller is bandwidth limited.

The method allows controlled synchronization at bandwidths that are beyond the direct synchronization error measurement limit through the use of additional reference signals. The issue with traditional synchronization methods is that they can be limited by the bandwidth limit of control hardware or measurement, such as in optical synchronization where shot noise can occur.

In some examples, a synchronization implementation is performed whose linearized behaviour is following the scheme in fig. 1, such that two controlled signals U1, U2, are fed to a plant P1, P2, which also have input signals X1, X2, respectively. Based on the dynamics of these plants, output signals Y1 and Y2 are generated that should become identical in time. Here, the signal U1, U2, is devised by a controller C1, C2 from an error signal E1,E2 generated by subtracting the control signals US1, US2 and (optionally identical) reference signal R1, R2, from the output signals Y1, Y2, and the signals US1, US2, are generated by a low-bandwidth controller C using the difference E between Y1 and Y2.

In some examples, the controller C is designed such that either US1 or US2 is zero or not implemented. In such an exemplary embodiment, the design of the control system may become simpler, since one of the lines carrying US1, US2, may be omitted.

In some examples, X1, X2, Y1, Y2, R1, R2 are the phase of optical signals and the optical part of the summands in the control loops is implemented by measuring interference amplitudes and the systems P1, P2 are optical phase-or frequency shifters.

In some examples, the process involves subtracting two optical signals, R2 and Y2, and then performing electronic subtraction with US2. Optical phase difference can be measured through interference.

There are several techniques available to adjust the phase, including the use of an acoustic-optical modulator, fiber stretcher, or electrical-optical modulator. For example, the acoustic-optical modulator approach involves generating a sound wave that creates a vibration in a crystal and reflecting light of it, resulting in a phase shift.

In some examples, phase difference is measured heterodyne. Alternatively, in some examples, the phase difference is measured homodyne.

In the above example of fig. 1, the first control system is configured to perform compensation of the first output signal and/or the second output signal further based on the second control signal generated by the second control system. However, it is also possible that, additionally or alternative, the second control system is configured to provide the one or more second control signals to at least one of the first dynamic system or the second dynamic system in order to compensate the first output signal or the second output signal, respectively. With other words, it is also envisaged that the second control system is configured to act on one or both of the dynamical systems directly. The second control system may thus be employed for direct and/or indirect control.

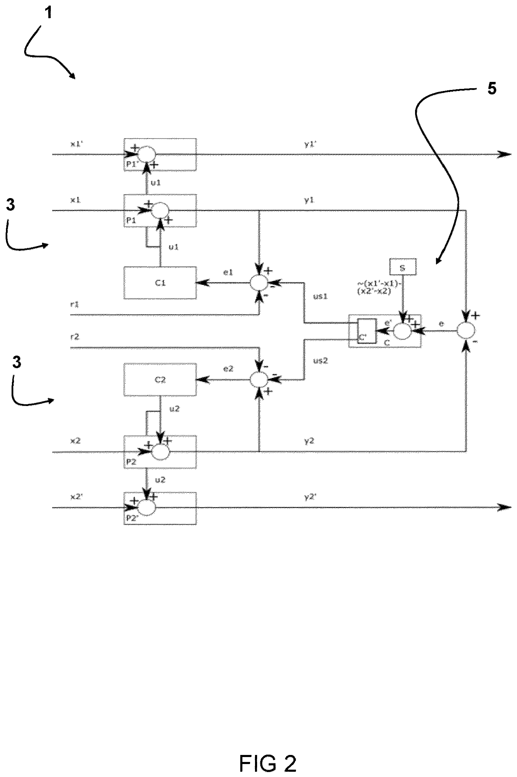

Fig. 2 shows a schematic diagram of an embodiment of a system 1. The control system shown in fig. 2 may be used for achieving synchronization between Y1' and Y2'. For example, this may involve light synchronization. However, the invention is not limited to optical/light applications.

The invention enables controlled synchronization at bandwidths that exceed the limit of direct synchronization error measurement by using one or more additional reference signals. The conventional methods for synchronizing two systems are often limited by the bandwidth of the control hardware or the measurement process, which can result in errors. For example, in optical synchronization processes, shot noise on single-photon detectors can impose a limit on the achievable bandwidth. Advantageously, a combination of fast and slow feedback loops can be employed according to the disclosure.

Two different wavelengths of light, X1 and X1', and X2 and X2', respectively are used for both sides of the system. The actuators mentioned, such as the acoustic-optical modulator, can add the same phase shift to both wavelengths. In some examples, the intensity/power on Y1' may be limited, whilst light with more intensity/power may be allowed for Y1. Hence, X1' and Y1' may have lower power (light intensity), but below that, a control system may be applied in parallel for synchronization with higher power (higher intensity).

In some examples, each optical input contains 2 wavelengths, i.e. X1 and X1' or X2 and X2', respectively, where the phase difference between X1 and X1' (or X2 and X2', respectively) are known or can be approximated, and U1 (or U2, respectively) consists of an optical phase shift applied at PS1 on both X1 and X1', (or applied at PS2 on X2 and X2', respectively) to generate the optical signal Y1 and Y1' (or Y2 and Y2'). Here, the signal U1, U2 is devised by a controller C1, C2 from an error signal E1, E2 generated by interfering Y1 with R1 at detector D1 (Y2 with R2 at D2, respectively) and subtracting the generated control signals US1, US2, where reference light inputs R1, R2 are used. The signals US1, US2 are generated by a low-bandwidth controller C using the interference output of detector D, interfering Y1 and Y2 as well as a proxy of the phase computation of (X1'-X1)-(X2'-X2) generated in an external logic S.

Advantageously, the invention may employ a combination of fast and slow feedback loops in a particular order, and the introduction of reference signals. In some examples, the phase difference at inputs can be determined. The measurement of Y1'-Y2' may not be possible, whilst X1-X1' and X2-X2' are known or estimated.

In some examples, the external logic is configured to perform direct measurements.

In some advantageous examples, the external logic is configured to estimate a relative phase difference between a first light beam and a second light beam guided through a common optical path, the first light beam having a first wavelength and the second light beam having a second wavelength different from the first wavelength, the system comprising a measurement unit configured to perform one or more measurements for measuring a value indicative of the physical pathlength variation, and a computing unit configured to calculate the relative phase difference between the first light beam and the second light beam at a predetermined location of the optical path based on the value indicative of the physical pathlength variation.

Optionally, the value indicative of the physical pathlength variation is determined by measuring an optical path delay of the optical path.

Optionally, the value indicative of the physical pathlength variation is determined by measuring a roundtrip time of the optical path.

Optionally, a third light beam with a third wavelength being different from the first and second wavelengths is guided through the optical path, and wherein the value indicative of the physical pathlength is determined based on a relative phase difference between the third light beam and a further light beam guided through the optical path.

Optionally, the further light beam is a fourth light beam additionally guided through the optical path, wherein the fourth light beam has a wavelength different from the first, second and third wavelengths.

Optionally, the further light beam corresponds to the first light beam or the second light beam.

Optionally, relative phase difference variation $\Delta\phi(t)$ is calculated based on the following relationship:

$$\Delta\phi(t) = 2\pi \left( \frac{n_1}{\lambda_1} - \frac{n_2}{\lambda_2} \right) \Delta L(t),$$

wherein $n_1$, $n_2$ are the optical indices of medium at the first and second wavelengths $\lambda_1, \lambda_2$, respectively, and $\Delta L(t)$ is the physical pathlength variation.

Optionally, an optical path delay variation $\Delta T(t)$ is measured at wavelength $\lambda_{forward}$ such as to determine the physical pathlength variation $\Delta L(t)$ based on the following relationship:

$$\Delta L(t) = \frac{c}{n_{forward}} \Delta T(t),$$

wherein $n_{forward}$ is an optical index at wavelength $\lambda_{forward}$.

Optionally, a roundtrip time variation $\Delta T^{rt}(t)$ is measured at wavelengths $\lambda_{forward}, \lambda_{backward}$ such as to determine the physical pathlength variation $\Delta L(t)$ based on the following relationship:

$$\Delta L(t) = \frac{c}{n_{forward} + n_{backward}} \Delta T^{rt}(t)$$

wherein $n_{forward}, n_{backward}$ are optical indices at wavelengths $\lambda_{forward}, \lambda_{backward}$.

Optionally, the physical pathlength variation is determined based on at least one of the following relationships:

$$\Delta L(t) = \frac{\Delta\phi_{34}(t)}{2\pi \left( \frac{n_3}{\lambda_3} - \frac{n_4}{\lambda_4} \right)},$$

$$\Delta L(t) = \frac{\Delta\phi_{31}(t)}{2\pi \left( \frac{n_3}{\lambda_3} - \frac{n_1}{\lambda_1} \right)},$$

wherein $\lambda_1, \lambda_3, \lambda_4$ are wavelengths of the first light beam, third light beam and the fourth light beam added to the optical path, respectively; $n_1, n_3, n_4$ are optical indices at wavelengths $\lambda_1, \lambda_3, \lambda_4$; $\Delta\phi_{34}(t)$ is a measured relative phase variation between the third and fourth light beams; and $\Delta\phi_{31}(t)$ is a measured relative phase variation between the third and first light beams.

Optionally, the optical path is parallel to a further adjacent optical path, wherein the first light beam and the second light beam are guided through the optical path and wherein the third light beam and the fourth light beam are guided through the further optical path, wherein the roundtrip time, optical path delay or phase difference between light at the third wavelength and the fourth wavelength are measured on light passing through the further optical path.

Optionally, the optical path and the further adjacent optical path are at least partially encapsulated in a same fiber duct.

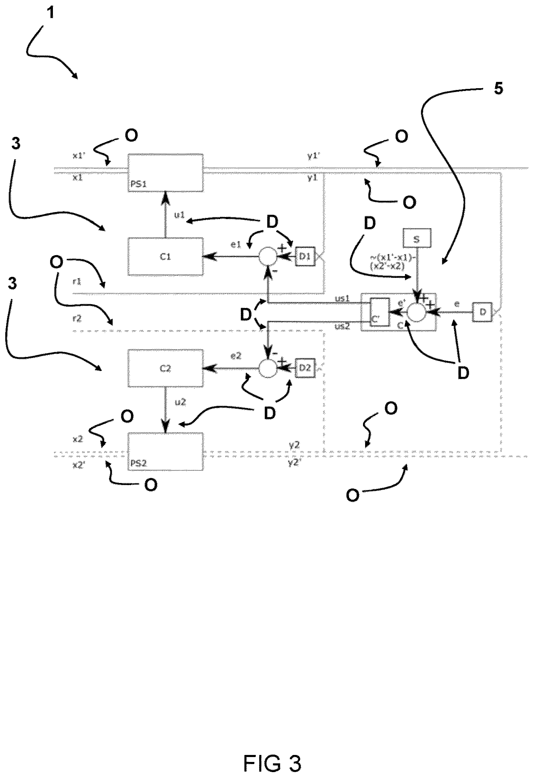

Fig. 3 shows a schematic diagram of an embodiment of a system 1. The control system shown in fig. 3 may be configured to perform optical synchronization between Y1' and Y2', with optical signals marked by O (lines in grey), and electronic or digital signals marked D (lines in black). It is also possible to use other electrical signals instead of digital signals.

In some examples, an error measurement between Y1' and Y2' may not be feasible (e.g. single photons). Further, the error between Y1 and Y2 may be bandwidth limited.

In some examples, the optical phase difference is measured heterodyne and the mixing frequency difference is used to distinguish Y1-US1-R1, from Y1'-US1-R1 from the interference at detector D1, Y2-US2-R2 from Y2'-US2-R2 from the interference at detector D2 and each of the signals Y1'-Y1,Y2'-Y2 and Y2'-Y1' from the interference at detector D between y2 and y1.

In some examples, the optical phase difference is measured homodyne and a difference in power allows to distinguish said signals.

In some examples, controller C is designed such that either US1 or US2 is zero or not implemented. If US1 or US2 is chosen to be zero, then a simpler design can be obtained. This can be done by the omission of path C to US2 control loop. Y1 can be made equal to Y2 and it is sufficient to adjust only one of the two signals. Hence, a simpler implementation excludes either US1 or US2, but the remaining elements, such as R1 and R2, remain unchanged.

In some cases, the actuators have limitations. So it can be advantageous if both actuators need to perform an equal share of the task (less relative burden compared to the case if only one actuator has to perform the adjustment).

It will be appreciated that the system and method according to the disclosure can be used in applications employing quantum interference between the paths of light using a single photon detector.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A method of controlling output signals of a system including at least a first dynamic system and a second dynamic system, wherein the first and second dynamic systems are configured to receive a first and second input signal and output a first and second output signal, respectively, wherein the method includes:

    providing a first control system that is configured to generate first control signals that are provided to the first dynamic system and the second dynamic system, respectively, in order to compensate the first output signal based on a difference between the first output signal and a first reference signal, and in order to compensate the second output signal based on a difference between the second output signal and a second reference signal;
    providing a second control system that is configured to generate one or more second control signals based on a difference between the first output signal and the second output signal;
    wherein the first control system is configured to perform compensation of the first output signal and/or the second output signal further based on the second control signal generated by the second control system; and/or wherein the second control system is configured to provide the one or more second control signals to at least one of the first dynamic system or the second dynamic system in order to compensate the first output signal or the second output signal, respectively; and

wherein a first closed-loop bandwidth is associated to the first control system, wherein a second closed-loop bandwidth is associated to the second control system, and wherein the first and second control systems are configured such that the second closed-loop bandwidth is smaller than the first closed-loop bandwidth.

2. The method according to claim 1, wherein the first operating bandwidth is selected such that high-frequency content in the difference between the first output signal and the second output signal is smaller than a limit imposed by the controller of the second control system due to its second operating bandwidth.

3. The method according to claim 1 or 2, wherein the first and second reference signals are selected such that a difference between the first and second reference signals and the first and second input signals, respectively, is smaller than a threshold value.

4. The method according to any one of the preceding claims, wherein the first control system is configured to perform compensation of both the first output signal and the second output signal based on the second control signal generated by the second control system; or wherein the first control system is configured to perform compensation of only one of the first output signal or the second output signal based on the second control signal generated by the second control system.

5. The method according to any one of the preceding claims, wherein the first and second dynamic systems are optical systems configured to receive first and second optical input signal and to output a first and second optical output signal, respectively, wherein the first and second optical input signals, the first and second optical output signals and the first and second reference signals are optical signals guided through optical light paths, and wherein nodes of the first and second control systems at which signals are added or subtracted are implemented by measuring interference amplitudes using one or more detectors

6. The method according to claim 5, wherein the first control system and the second control system are employed for phase locking the first and second optical input signals.

7. The method according to claim 5 or 6, wherein the first and second dynamic optical systems are optical phase shifters or optical frequency shifters.

8. The method according to any one of the preceding claims 5-7, wherein the first dynamic optical system is configured to receive at least two first optical input signals with different wavelengths, and wherein the second dynamic optical system is configured to receive at least two second optical input signals with different wavelengths, wherein a phase difference between the at least two first optical input signals and a phase difference between the at least two second optical input signals is determined, and wherein the first and/or second control signals are employed to apply optical phase shifts at the respective first and/or second dynamic optical systems to the at least two first and/or second optical input signals, respectively, to generate the at least two first and/or second optical output signals of the respective first and/or second dynamic optical systems.

9. The method according to any one of the preceding claims 5-8, wherein a primary first control signal is generated by the first control system based on an error signal obtained by interfering the first output signal with the first reference signal at a first detector and subtracting the second control signal received from the second control system, and wherein a secondary first control signal is generated by the first control system based on an error signal obtained by interfering the second output signal with the second reference signal at a second detector and subtracting the second control signal received from the second control system.

10. The method according to any one of the preceding claims 5-9, wherein the one or more second control signals are generated by the second control system based on an interference between the first output signal and a second output signal, and further based on the phase difference between the at least two first optical input signals and a phase difference between the at least two second optical input signals.

11. The method according to any one of the preceding claims, wherein the first and second reference signals are different.

12. The method according to any one of the preceding claims 1-10, wherein the first and second reference signals are the same.

13. The method according to any one of the preceding claims 5-12, wherein optical phase differences are measured heterodyne.

14. The method according to any one of the preceding claims 5-12, wherein optical phase differences are measured homodyne.

15. A control system for controlling output signals of a system including at least a first dynamic system and a second dynamic system, wherein the first and second dynamic systems are configured to receive a first and second input signals and output a first and second output signal, respectively, wherein the system includes:

a first control system configured to generate control signals that are provided to the first dynamic system and the second dynamic system, respectively, in order to compensate the first output signal based on a difference between the first output signal and a first reference signal, and in order to compensate the second output signal based on a difference between the second output signal and a second reference signal; a second control system configured to generate one or more second control signals based on a difference between the first output signal and the second output signal;
wherein the first control system is configured to perform compensation of the first output signal and/or the second output signal further based on the second control signal generated by the second control system; and/or wherein the second control system is configured to provide the one or more second control signals to at least one of the first dynamic system or the second dynamic system in order to compensate the first output signal or the second output signal, respectively; and
wherein a first closed-loop bandwidth is associated to the first control system, wherein a second closed loop bandwidth is associated to a second control system, and wherein the first and second control systems are configured such that the second closed-loop bandwidth is smaller than the first closed-loop bandwidth.

FIG 1

FIG 2

FIG 3

# EP 4 443 771 A1

Europäisches
Patentamt
European
Patent Office
Office européen
des brevets

## EUROPEAN SEARCH REPORT

Application Number

EP 23 16 6388

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2010/099372 A1 (WANG CHENG-HAN [US] ET AL) 22 April 2010 (2010-04-22) * paragraphs [0047] – [0040], [0056], [0065] – [0067]; figure 2a * ----- | 1–15 | INV. H04B10/61 G05B13/00 H03L7/00 |
| A | US 2014/300108 A1 (SAHUKARI SRIDHAR [GB] ET AL) 9 October 2014 (2014-10-09) * paragraphs [0077], [7872] – [0074]; figures 2,4 * ----- | 1–15 | |
| A | US 7 636 525 B1 (BONTU CHANDRA [CA] ET AL) 22 December 2009 (2009-12-22) * column 9, line 44 – column 11, line 41; figures 7c,10 * ----- | 1–15 | |

TECHNICAL FIELDS
SEARCHED (IPC)

H04B
G05B
H03L

The present search report has been drawn up for all claims

| Place of search | Date of completion of the search | Examiner |
|---|---|---|
| Munich | 25 September 2023 | Koch, Bernhard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 6388

This annex lists the patent family members relating to the patent documents cited in  the above-mentioned European search report.
The members are as contained in the European Patent Office EDP file on
The European Patent Office is in no way liable for these particulars which are merely given for the purpose of information.

25-09-2023

| Patent document cited in search report | | Publication date | Patent family member(s) | | Publication date |
|---|---|---|---|---|---|
| US 2010099372 | A1 | 22-04-2010 | TW | 201031112 A | 16-08-2010 |
| | | | US | 2010099372 A1 | 22-04-2010 |
| | | | WO | 2010048232 A1 | 29-04-2010 |
| US 2014300108 | A1 | 09-10-2014 | EP | 2761172 A1 | 06-08-2014 |
| | | | ES | 2615263 T3 | 06-06-2017 |
| | | | US | 2014300108 A1 | 09-10-2014 |
| | | | WO | 2013044923 A1 | 04-04-2013 |
| US 7636525 | B1 | 22-12-2009 | US | 7606498 B1 | 20-10-2009 |
| | | | US | 7636525 B1 | 22-12-2009 |
| | | | US | 7684712 B1 | 23-03-2010 |
| | | | US | 7769305 B1 | 03-08-2010 |
| | | | US | 7894728 B1 | 22-02-2011 |
| | | | US | 7899340 B1 | 01-03-2011 |
| | | | US | 7936999 B1 | 03-05-2011 |
| | | | US | 8463133 B1 | 11-06-2013 |
| | | | US | 2013259493 A1 | 03-10-2013 |

EPO FORM P0459

For more details about this annex : see Official Journal of the European Patent Office, No. 12/82